# EUROPEAN PATENT APPLICATION

(11) **EP 1 659 410 A2**
(43) Date of publication of application: **24.05.2006**
(21) Application number: 06000289.6
(22) Date of filing: 15.05.1997
(51) Int. Cl.: G01R 1/073

(54) **Contact tip structures for microelectronic interconnection elements and methods of making same**

(30) Priority: 17.05.1996 US 5189 P; 24.05.1996 WO PCT/US96/08107; 27.06.1996 US 20869 P; 22.08.1996 US 24405 P; 26.08.1996 US 24555 P; 13.11.1996 US 30697 P; 13.12.1996 US 32666 P; 31.12.1996 US 34053 P; 15.01.1997 US 784862; 24.01.1997 US 788740; 18.02.1997 US 802054; 17.03.1997 US 819464; 06.05.1997 US 852152
(62) Divisional of application: 97925668.2
(71) Applicant: FormFactor, Inc., Livermore, CA 94551 (US)
(72) Inventor: Khandros, Igor, Y., Orinda, CA 94563 (US); Eldgridge, Benjamin, N., Danville, CA 94526 (US); Mathieu, Gaetan, L., Varennes, QC J3X 1P7 (CA); Dozier, Thomas H., Livermore, CA 94550 (US); Taylor, Sheldon, A., Mountain View, CA 94040 (US)
(74) Representative: Käck, Jürgen

(57) **Abstract**

Contact tip structures are fabricated on sacrificial substrates for subsequent joining to interconnection elements including composite interconnection elements, monolithic interconnection elements, tungsten needles of probe cards, contact bumps of membrane probes, and the like. The spatial relationship between the tip structures can lithographically be defined to very close tolerances. The metallurgy of the tip structures is independent of that of the interconnection element to which they are attached, by brazing, plating or the like. The contact tip structures are readily provided with topological (small, precise, projecting, non-planar) contact features, such as in the form of truncated pyramids, to optimize electrical pressure connections subsequently being made to terminals of electronic components. Elongate contact tip structures, adapted in use to function as spring contact elements without the necessity of being joined to resilient contact elements are described. Generally, the invention is directed to making (pre-fabricating) relatively "perfect" contact tip structures ("tips") and joining them to relatively "imperfect" interconnection elements to improve the overall capabilities of resulting "tipped" interconnection elements.

## Description

### TECHNICAL FIELD OF THE INVENTION

The invention relates to interconnection (contact) elements for microelectronic applications and, more particularly, to contact elements which are resilient (springy) contact elements suitable for effecting pressure connections between electronic components.

### CROSS-REFERENCE TO RELATED APPLICATIONS

This patent application is a continuation-in-part of commonly-owned, copending U.S. Patent Application No. **08/452,255** (hereinafter **"PARENT CASE")** filed 26 May 95 and its counterpart PCT patent application number **PCT/US95/14909** filed 13 NOV 95, both of which are continuations-in-part of commonly-owned, copending U.S. Patent Application No. **08/340,144** filed 15 Nov 94 and its counterpart PCT patent application number **PCT/US94/13373** filed 16 Nov 94, both of which are continuations-in-part of commonly-owned, copending U.S. Patent Application No. **08/152,812** filed 16 Nov 93 (now USP **5,476,211,** 19 Dec 95), all of which are incorporated by reference herein.

This patent application is also a continuation-in-part of the following commonly-owned, copending U.S. Patent Application Nos.:
**08/526,246** filed 21 SEP 95 (PCT/US95/14843, 13 NOV 95);
**08/554,902** filed 09 NOV 95 (PCT/US95/14844, 13 NOV 95);
**08/558,332** filed 15 NOV 95 (PCT/US95/14885, 15 NOV 95);
**08/602,179** filed 15 FEB 96 (PCT/US96/08328, 28 MAY 96);
**60/012,027** filed 21 FEB 96 (PCT/US96/08117, 24 MAY 96);
**60/012,878** filed 05 MAR 96 (PCT/US96/08274, 28 MAY 96);
**60/013,247** filed 11 MAR 96 (PCT/US96/08276, 28 MAY 960; and
**60/005,189** filed 17 MAY 96 (PCT/US96/08107, 24 MAY 96),
all of which (except for the provisional patent applications listed) are continuations-in-part of the aforementioned PARENT CASE, and all of which are incorporated by reference herein.

This patent application is also a continuation-in-part of commonly-owned, copending U.S. Patent Application Nos.:
**60/020,869** filed 27 JUN 96;
**60/024,405** filed 22 AUG 96;
**60/024,555** filed 26 AUG 96;
**60/030,697** filed 13 NOV 96;
**60/034,053** filed 31 DEC 96; and
**08/802,504** filed 18 FEB 97 by Eldridge, Grube, Khandros, and Mathieu, incorporated by reference herein.

### BACKGROUND OF THE INVENTION

Generally, interconnections between electronic components can be classified into the two broad categories of "relatively permanent" and "readily demountable".

An example of a "relatively permanent" connection is a solder joint. Once two electronic components are soldered to one another, a process of unsoldering must be used to separate the components. A wire bond, such as between a semiconductor die and inner leads of a semiconductor package (or inner ends of leadframe fingers) is another example of a "relatively permanent" connection.

An example of a "readily demountable" connection is rigid pins of one electronic component being received by resilient socket elements of another electronic component.

Another type of readily demountable connection is interconnection elements which themselves are resilient, or springy. or are mounted in or on a springy medium. An example of such a spring contact element is a tungsten needle of a probe card component. Such spring contact elements are intended to effect typically temporary pressure connections between a component to which they are mounted and terminals of another component, such as a semiconductor device under test (DUT). Problems with tungsten needles include difficulties in grinding their tips to have an appropriate shape, they don't last long, and they require frequent rework.

Generally, a certain minimum contact force is desired to effect reliable pressure contact to electronic components (e.g., to terminals on electronic components). For example, a contact (load) force of approximately 15 grams (including as little as 2 grams or less and as much as 150 grams or more, per contact) may be desired to ensure that a reliable electrical pressure connection is made to a terminal of an electronic component which may be contaminated with films on the surface of its terminals, or which has corrosion or oxidation products on its surface.

In addition to establishing and maintaining an appropriate minimum contact force, another factor of interest is the shape (including surface texture) and metallurgy of the ends of the spring contact element making pressure connections to the terminals of the electronic components. Returning to the example of tungsten needles as probe elements, the metallurgy of the contact end is evidently limited by the metallurgy (i.e., tungsten) of the interconnection element and, as these tungsten needles become smaller and smaller in diameter, it becomes commensurately more difficult to control or establish a desired shape at their contact ends.

In certain instances, the contact elements themselves are not resilient, but rather are supported by a resilient member. Membrane probes exemplify this situation, wherein a plurality of microbumps are disposed on a resilient membrane. Again, the technology required to manufacture such interconnection elements limits the design choices for the shape and metallurgy of the contact portions of such interconnection elements.

An example of an elongate spring contact element is disclosed in the PARENT CASE **(PCT/US95/14909)** which describes the fabrication of resilient contact structures (spring elements) as **"composite"** interconnection elements by mounting a free-standing wire stem (elongate element) on a terminal of an electronic component, shaping the wire stem, severing the wire stem to be free-standing, and overcoating the free-standing wire stem to impart the desired resiliency to the resulting free-standing spring element. The overcoat material also extends contiguously over the adjacent surface of the terminals to which the wire stems are mounted to provide firmly anchor the resulting composite interconnection elements to the terminals. Although these elongate, composite, resilient interconnection elements will benefit from the present invention, the present invention is not limited thereto.

### BRIEF DESCRIPTION (SUMMARY) OF THE INVENTION

It is an object of the present invention to provide an improved technique for fabricating interconnection elements, particularly for use in interconnecting microelectronic components.

It is another object of the invention to provide resilient contact structures (interconnection elements) that are suitable for making pressure connections with terminals of electronic components.

It is another object of the invention to provide a technique for joining prefabricated contact tip structures to existing contact elements.

It is another object of the invention to provide contact tip structures which may be fabricated independent of interconnection elements to which they are joined.

The invention is defined in claim 1. Particular embodiments of the invention are set out in the dependent claims.

According to the invention, contact tip structures are pre-fabricated on sacrificial substrates, and subsequently are joined to other (existing) interconnection elements, after which the sacrificial substrate is removed (separated from the resulting "tipped" interconnection elements).

Said interconnection elements may or may not be elongate, and may or may not be resilient (spring) contact elements. Said interconnection elements may be "composite" or "monolithic", and include tungsten needles of probe cards and bump elements of membrane probes.

According to a feature of the invention, the contact tip structures are joined by brazing or by plating to the interconnection elements. Alternatively, the contact tip structures can be joined to the interconnection elements with a conductive adhesive (e.g., silver-filled epoxy) or the like.

According to a feature of the invention, various metallurgies and topologies (contact features) are described for the contact tip structures.

According to an aspect of the invention, a plurality of contact tip structures are readily fabricated on a sacrificial substrate to extremely close tolerances using conventional semiconductor processing techniques (e.g., photolithography, deposition), including micromachining techniques, as well as "mechanical" techniques, so as to have a prescribed spatial relationship with one another. So long as the contact tip structures remain resident on the sacrificial substrate, these tolerances and spatial relationships are well preserved. After the contact tip structures are joined with interconnection elements, these tolerances will be preserved by the interconnection elements.

Generally, the invention facilitates the construction of electrical contact structures by joining a plurality of contact tip structures having a relatively precise positional relationship with one another to a corresponding plurality of interconnection elements which may be disposed in relatively rough (coarse) relationship with one another. Preferably, each contact tip structure has a topological contact feature portion on its body portion which is disposed in relatively precise relationship to other ones of the topological contact features, so that the body portions of the tip structures need not be located so precisely with respect to one another. These topological contact features are readily formed with great positional precision by etching the sacrificial substrate upon which the contact tip structure is pre-fabricated so that they take the form (shape) of pyramids, truncated pyramids, and the like, using conventional semiconductor fabrication processes including micromachining.

According to a feature of the invention, various sacrificial substrates are described, as well as methods for separating the pre-fabricated contact structures from the sacrificial substrates upon which they are resident.

For example, the sacrificial substrate may be a silicon wafer which is processed using micromachining techniques to have depressions, including features, wherein the contact tip structures of the present invention are fabricated by depositing one or more conductive metallic layers into the depressions and features.

The invention permits contact tip structures to be pre-fabricated which have surface texture (roughness and shape; geometry, topology), and metallurgy, and which are of a size that are not limited by the materials and considerations attendant the manufacture of the interconnection elements to which they are joined. A sacrificial substrate upon which a plurality of contact tip structures have been pre-fabricated is suitably sold as a finished product, in and of itself, to others who desire to join the contact tip structures to their interconnection elements.

An important feature of the present invention is that a plurality of contact tip structures are readily fabricated on a sacrificial substrate to extremely precise tolerances, for example, by using known semiconductor fabrication processes such as masking, lithography and deposition to control their size and spacing.

According to an aspect of the invention, elongate contact tip structures are fabricated which, in and of themselves, are suited in use to function as spring contact elements, without requiring joining to existing interconnection elements.

These elongate contact tip structures which function as spring contact elements can be flat, and joined at their base ends to conductive pedestals on a surface of an electronic component so that there is a space between the elongate contact tip structure and the surface of the electronic component within which the contact end of the elongate contact tip structure may deflect.

These elongate contact tip structures which function as spring contact elements may also be three-dimensional in that their base ends are offset in a one direction from their central body portions and so that their contact ends are offset in an opposite direction from their central body portions.

The elongate contact tip structures of the present invention can have alternating orientations (e.g., left-right-left-right) so as to achieve a greater (coarser) pitch between their base ends than at their contact ends.

The elongate contact tip structures of the present invention can have alternating lengths (e.g., short-long-short-long) so as to achieve a greater (coarser) pitch between their base ends than at their contact ends.

Tapering the width and/or thickness of elongate contact tip structures between their base ends and their contact ends is disclosed.

Techniques are disclosed for tailoring (adjusting) the force which elongate contact tip structures will exert in response to contact forces applied at their contact ends.

The present invention provides a technique for fabricating relatively 'perfect' (extremely uniform and reproducible to close tolerances) contact tip structures and 'marrying' them to relatively 'imperfect' interconnection elements. Due to the constraints associated with making interconnection elements, certain tradeoffs are often required vis-a-vis the tip geometry and metallurgy, and overall spatial uniformity of the interconnection elements. And, if they can't be reworked, they must be replaced. The present invention solves this limitation by freeing up the tip metallurgy, geometry, and topology from that of the interconnection element to which it is joined, with lithographically precise uniformity.

Other objects, features and advantages of the invention will become apparent in light of the following description thereof.

### BRIEF DESCRIPTION OF THE DRAWINGS

Reference will now be made in detail to preferred embodiments of the invention, examples of which are illustrated in the accompanying drawings. Although the invention will be described in the context of these preferred embodiments, it should be understood that it is not intended to limit the spirit and scope of the invention to these particular embodiments.

In the side views presented herein, often only portions of the side view are presented in cross-section, and portions may be shown in perspective, for illustrative clarity.

In the figures presented herein, the size of certain elements are often exaggerated (not to scale, vis-a-vis other elements in the figure), for illustrative clarity.
**Figure 1A** is a perspective view, partially exploded, of a generalized embodiment of the invention, illustrating pre-fabricated contact tip structures (102) and interconnection elements (106) to which they will be joined, according to the invention.
**Figure 1B** is a side cross-sectional view of the contact tip structures (102) of **Figure 1A** joined by brazing to the interconnection elements (106) of **Figure 1A**, according to the invention.
**Figure 1C** is a side cross-sectional view, partially in perspective, of the contact tip structures (102) of **Figure 1A** joined by plating to the interconnection elements (106) of **Figure 1A**, according to the invention.
**Figure 1D** is a side cross-sectional view of the contact tip structures (102) of **Figure 1A** joined by brazing (compare **Figure 1B)** to the interconnection elements (106) of **Figure 1A**, after the sacrificial substrate (104) is removed, according to the invention.
**Figure 2A** is a cross-sectional view of a technique for fabricating contact tip structures for interconnection elements, according to the invention.
**Figure 2B** is a cross-sectional view of further steps in the technique of **Figure 2A**, according to the invention.
**Figure 2C** is a side view, partially in cross-section, of the contact tip structures (220) of **Figure 2B** being joined to existing interconnection elements (252), according to the invention.
**Figure 2D** is a side view, partially in cross-section, of a further (final) step in joining the interconnection elements (252) of **Figure 2C** joined with the contact tip structures (220 of **Figure 2B,** after removal of the sacrificial substrate (202), according to the invention.
**Figure 3A** is a side, cross-sectional view of an embodiment wherein the contact tip structures of the present invention are affixed to a type of elongate interconnection elements, according to the invention.
**Figure 3B** is a side, cross-sectional view of another embodiment wherein the contact tip structures of the present invention are affixed to a type of elongate interconnection elements, according to the invention.
**Figure 3C** is a side, cross-sectional view of another embodiment wherein the contact tip structures of the present invention are affixed to a type of interconnection elements, according to the invention.
**Figure 4A** is a side cross-sectional view of a technique for fabricating a multilayer contact tip structure, according to the invention.
**Figure 4B** is a side cross-sectional view of a technique for forming a contact tip structure (440) on a sacrificial substrate (424) and a technique for releasing the sacrificial substrate, according to the invention.
**Figure 5A** is a perspective view of a first step in fabricating a plurality of contact tip structures on a sacrificial substrate, according to the invention.
**Figure 5B** is a side cross-sectional view, taken on the line 5B-5B through **Figure 5A**, of another step in fabricating contact tip structures on a sacrificial substrate, according to the invention.
**Figure 5C** is side cross-sectional view of another step in fabricating contact tip structures on a sacrificial substrate, according to the invention.
**Figure 5D** is a side cross-sectional view of a contact tip structure which has been fabricated on a sacrificial substrate, according to the invention.
**Figure 5E** is a perspective view of a contact tip structure which has been joined to an interconnection element, according to the invention.
**Figure 5F** is a side cross-sectional view of a contact tip structure which has been joined to a different interconnection element, according to the invention.
**Figure 6A** is perspective view of a technique for preparing a sacrificial substrate for the fabrication of a contact tip structure, according to the invention.
**Figure 6B** is a perspective view of a contact tip structure (620) joined to an end of an interconnection element (shown in dashed lines), according to the invention.
**Figures 7A-7C** are cross-sectional views of steps in a process of manufacturing elongate contact tip structures on a sacrificial substrate according to the invention.
**Figure 7D** is a perspective view of an elongate contact tip structure formed on a sacrificial substrate, according to the invention.
**Figure 7E** is a perspective view of a plurality of elongate contact tip structures formed on a sacrificial substrate, according to the invention.
**Figure 7F** is a side cross-sectional view, of a technique for mounting elongate contact tip structures (720) to an electronic component (734), according to the invention.
**Figure 8** is a perspective view of an embodiment illustrating the fabrication of a plurality of elongate contact tip structures having alternating lengths, according to the invention.
**Figure 9A** is a cross-sectional view of an elongate contact tip structure suitable for use as a resilient interconnection element (spring contact element), according to the invention.
**Figure 9B** is a plan view of the spring contact element of **figure 9A**, according to the invention.
**Figure 9C** is a cross-sectional view of an alternate embodiment of a spring contact element, according to the invention.
**Figure 9D** is an enlarged cross-sectional view of a portion of the spring contact element of **Figure 9C.**
**Figure 9E** is a cross-sectional view of an alternate embodiment of a spring contact element, according to the invention.
**Figures 10A-10D** are side cross-sectional views of alternate techniques for tailoring the mechanical characteristic of elongate contact tip structures (spring contact elements), according to the invention.
**Figures 11A and 11B** are perspective views of alternate spring contact elements, according to the invention.

### DETAILED DESCRIPTION OF THE INVENTION

The present invention is generally directed to pre-fabricating contact tip structures, and subsequently joining them to existing interconnection elements so as to obtain one or more of the following benefits:
(a) the contact tip structures of the present invention are readily provided with a distinct surface texture, roughness and shape (geometry, topology) which is specifically adapted to the terminal metallurgy of the electronic component(s) ultimately being contacted by the tips of the interconnection elements to which they are joined, independent of the surface texture of the interconnection elements to which they are joined, to optimize pressure connections being made by the "tipped" interconnection elements with specific terminals of electronic components for different applications;
(b) the contact tip structures of the present invention are readily fabricated with any suitable metallurgy, including entirely independent of and dissimilar from that of the interconnection elements to which they are joined; and
(c) the contact tip structures of the present invention are readily fabricated to extremely precise tolerances, with respect to the planarity of a plurality of contact tip structures and with regard to the spacing between individual ones of the plurality of contact tip structures, virtually independent of tolerance limitations attendant to the interconnection elements to which they are joined; and
(d) the contact tip structures of the present invention are readily fabricated to have a critical dimension (e.g., diameter) which is independent of and larger than a corresponding dimension (e.g., cross-section diameter) of the interconnection elements to which they are joined.

Existing interconnection elements such as elongate and/or resilient interconnection elements will benefit from having the contact tip structures of the present invention joined thereto.

### A "GENERALIZED" EMBODIMENT

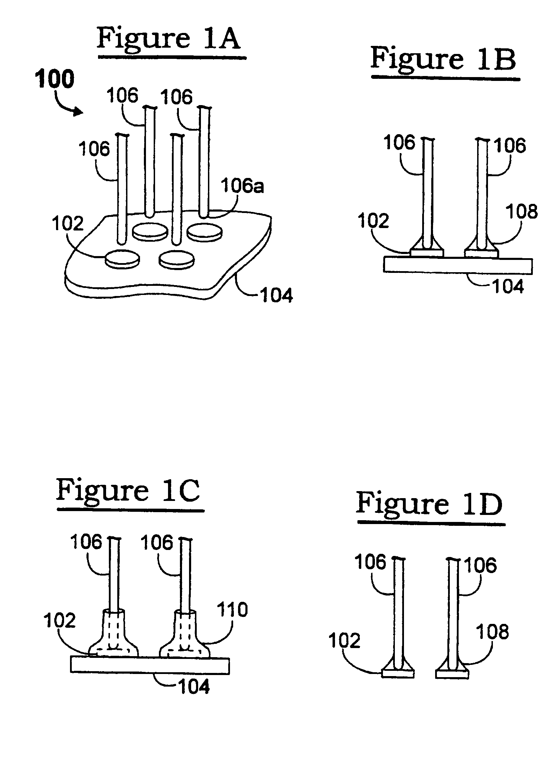

**Figure 1A** illustrates a generalized embodiment 100 of the invention wherein a plurality (four of many shown) of contact tip structures 102 have been pre-fabricated upon a support (sacrificial) substrate 104, in a manner described hereinbelow. A corresponding plurality (four of many shown) of interconnection elements 106 (only the distal ends and tips of these elongate interconnection elements are illustrated) are shown in preparation for having their free ends 106a joined to the contact tip structures 102 (or vice-versa). The free ends 106a of the elongate interconnection elements 106 are distant (distal) from opposite ends (not shown) of the elongate interconnection elements 106 which typically would extend from a surface of an electronic component (not shown) such as a semiconductor device, a multilayer substrate, a semiconductor package, etc.

The support (sacrificial) substrate 104 with prefabricated contact tip structures 102 resident thereon is fabricated separately from, prior to, and by an entirely different process than, the elongate interconnection elements 106.

**Figure 1B** illustrates, in side view, a next step of joining the contact tip structures 102 to the elongate interconnection elements 106 by brazing. A resulting braze fillet 108 is illustrated. The contact tip structures 102 are still resident on the sacrificial substrate 104 in their prescribed spatial relationship with one another. **Figure 1B** is also illustrative of the contact tip structures 102 being joined to the elongate interconnection elements with conductive adhesive (e.g., silver-filled epoxy) or the like.

**Figure 1C** illustrates, in side view, an alternate next step of joining the contact tip structures 102 to the elongate interconnection elements 106 by overcoating at least the junction of the contact tip structures 102 and adjacent end portions of the elongate interconnection elements 106 with a metallic material 110 such as nickel, such as by plating. Although not specifically shown, it should be understood that the overcoating material 110 may extend along (cover) the full length of the elongate interconnection element 106.

**Figure 1D** illustrates, in side view, a step subsequent to the steps illustrated in either of **Figures 1B or 1C** wherein, after joining the contact tip structures 102 to the elongate interconnection elements 106, the support (sacrificial) substrate 104 is removed. Techniques for removing the sacrificial substrate are described hereinbelow. The resulting "tipped" interconnection element 106 (as used herein, a "tipped" interconnection element is an interconnection element which has had a separate contact tip structure joined thereto) is shown as having had a contact tip structure 102 brazed (108) thereto, in the manner described with respect to **Figure 1B.**

In this manner, the contact tip structures 102 can be at different (more precise) tolerance spacing than the interconnection elements 106, can have different metallurgy than the interconnection elements 106, and can have a topology (described hereinbelow) which is not otherwise attainable for the interconnection elements 106.

Materials for the contact tip structures (102) and the sacrificial substrate (104), as well as suitable techniques for pre-fabricating the contact tip structures (102) and for removing the sacrificial substrate after joining the contact tip structures (102) to the interconnection elements (106), are described in greater detail hereinbelow.

### AN EXEMPLARY OVERALL METHOD, AND RESULTING "TIPPED" INTERCONNECTION ELEMENTS

As mentioned hereinabove, many advantages accrue to pre-fabricating contact tip structures (on a sacrificial substrate) and subsequently joining the contact tip structures to interconnection elements which have been fabricated separately from the contact tip structures.

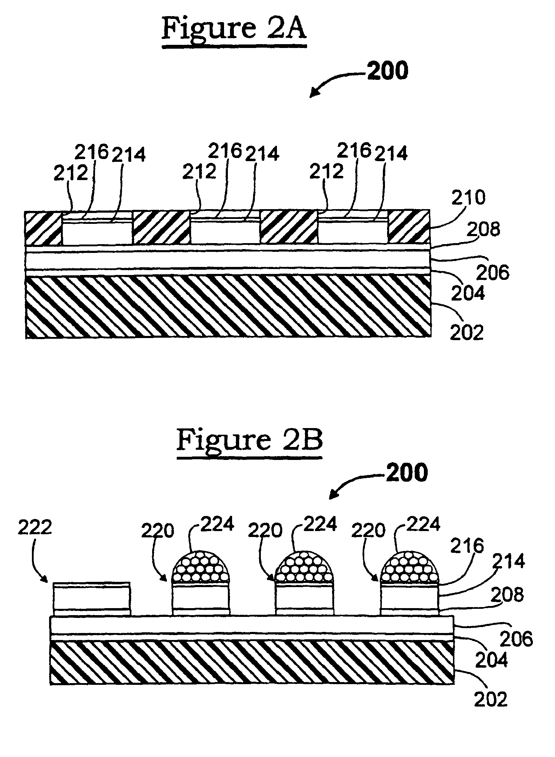

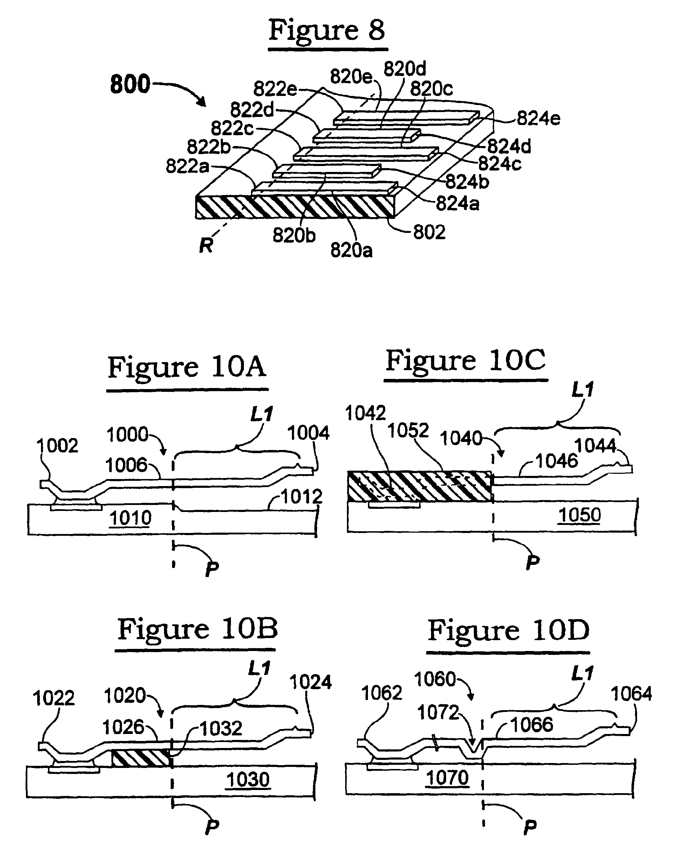

**Figures 2A-2D** illustrate a technique for prefabricating contact tip structures on a sacrificial substrate, joining the contact tip structures to the exemplary elongate interconnection elements, and removing the sacrificial substrate, and correspond generally to Figures 8A-8E of the aforementioned **PCT/US95/14844.**

**Figure 2A** illustrates a technique 200 for fabricating contact tip structures on a sacrificial substrate 202. In this example, a silicon substrate (wafer) 202 having a top (as viewed) surface is used as the sacrificial substrate. A layer 204 of titanium is deposited (e.g., by sputtering) onto the top surface of the silicon substrate 202, and suitably has a thickness of approximately **250 Å** (1Å = 0.1 nm = 10⁻¹⁰ m). A layer 206 of aluminum is deposited (e.g., by sputtering) atop the titanium layer 204, and suitably has a thickness of approximately **20.000 Å.** The titanium layer 204 is optional and serves as an adhesion layer for the aluminum layer 206. A layer 208 of copper is deposited (e.g., by sputtering) atop the aluminum layer 206, and suitably has a thickness of approximately **5,000 Å.**

A layer 210 of masking material (e.g., photoresist) is deposited atop the copper layer 208, and has a thickness of approximately **2 mils**. The masking layer 210 is processed in any suitable manner to have a plurality (three of many shown) of holes (openings) 212 extending through the photoresist layer 210 to the underlying copper layer 208. For example, each hole 212 may be **6 mils** in diameter, and the holes 212 may be arranged at a pitch (center-to-center) of **10 mils**. The sacrificial substrate 202 has, in this manner, been prepared for fabricating a plurality of contact tip structures at what are "lithographically-defined" locations on the sacrificial substrate 202, within the holes 212. Exemplary contact tip structures may be formed, as follows:

A layer 214 of nickel is deposited, such as by plating, within the holes 212, onto the copper layer 208, and suitably has a thickness of approximately **1.0 -1.5 mils**. Optionally, a thin layer (not shown) of a noble metal such as rhodium can be deposited onto the copper layer 208 prior to depositing the nickel. Next, a layer 216 of gold is deposited, such as by plating, onto the nickel 214. The multi-layer structure of nickel and gold (and, optionally, rhodium) will serve as a pre-fabricated contact tip structure (220, as shown in **Figure 2B).**

Next, as illustrated in **Figure 2B,** the photoresist 210 is stripped away (using any suitable solvent), leaving a plurality of pre-fabricated tip structures 220 sitting atop the copper layer 208. Next, the exposed (i.e., not covered by contact tip structures 220) portion of the copper layer 208 is subjected to a quick etch process, thereby exposing the aluminum layer 206. As will be evident, aluminum is useful in subsequent steps, since aluminum is substantially non-wettable with respect to most solder and braze materials.

It bears mention that it is preferred to pattern the photoresist with additional holes (not shown, comparable to 212) within which "ersatz" contact tip structures 222 may be fabricated in the same process steps employed to fabricate the actual contact tip structures 220. These ersatz contact tip structures 222 will serve to uniformize the aforementioned plating steps (214, 216) in a manner that is well known and understood, by reducing abrupt gradients (non-uniformities) from manifesting themselves across the surface being plated. Such structures (222) are typically referred to in the field of plating as "robbers".

In this manner, a plurality of contact tip structures 220 have successfully been pre-fabricated on a sacrificial substrate 202, awaiting subsequent joining to a corresponding plurality of interconnection elements. Optionally, as part of the prefabrication of contact tip structures (alternatively, immediately prior to joining the contact tip structures to the interconnection elements), solder or brazing paste ("joining material") 224 is deposited onto the top (as viewed) surfaces of the tip structures 220. (There is no need to deposit the paste onto the tops of the ersatz tip structures 222). This is implemented in any suitable manner, such as with a stainless steel screen or stencil or by automated dispensing of solder paste, as is known in the art. A typical paste (joining material) 224 would contain gold-tin alloy (in a flux matrix) exhibiting, for example, **1 mil** spheres (balls).

The contact tip structures 220 are now ready to be joined (e.g., brazed) to ends (tips) of interconnection elements such as, but not limited to, the composite interconnect elements of the aforementioned PARENT CASE **(PCT/US95/14909).**

The contact tip structures (220), as fabricated upon and resident upon a sacrificial substrate (202), constitute a product in and of itself and, as described in greater detail hereinbelow, can subsequently be joined to a wide variety of pre-existing interconnection elements.

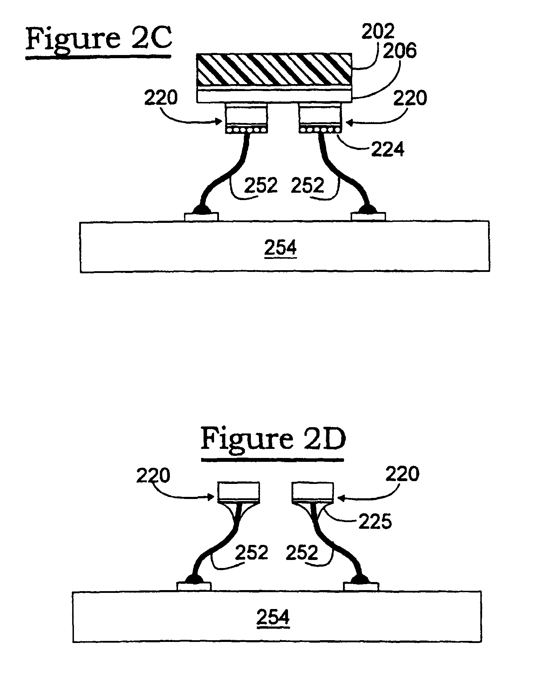

The sacrificial substrate with contact tip structures resident thereon is now brought to bear upon tips (free ends) of exemplary elongate interconnection elements 252 extending from an exemplary substrate 254 which may be an electronic component. As shown in **Figure 2C,** the contact tip structures 220 (only two contact tip structures are shown in the view of **Figure 2D,** for illustrative clarity) are aligned with the tips (distal ends) of the interconnection elements 252, using standard flip-chip techniques (e.g., split prism), and the assembly is passed through a brazing furnace (not shown) to reflow the joining material 224, thereby permanently joining (e.g., brazing) the prefabricated contact tip structures 220 to the ends of the interconnection elements 252.

During the reflow process, the exposed aluminum layer (206), being non-wettable, prevents solder (i.e., braze) from flowing between the contact tip structures 220, i.e., prevents solder bridges from forming between adjacent contact tip structures.

In addition to this anti-wetting function of the aluminum layer 206, the aluminum layer 206 also serves to provide a release mechanism. Using a suitable etchant, the aluminum is preferentially (to the other materials of the assembly) etched away, and the silicon sacrificial substrate 202 simply "pops" off, resulting in a substrate or electronic component 254 having "tipped" interconnection elements 252, each having a prefabricated tip structure 220, as illustrated in **Figure 2D.** (Note that the joining material 224 has reflowed as "fillets" 225 on end portions of the interconnection elements 252.)

In a final step of the process, the residual copper (208) is etched away, leaving the contact tip structures 220 with nickel (or rhodium, as discussed hereinabove) exposed for making reliable electrical pressure connections to terminals (not shown) of other electronic components (not shown).

It is within the scope of the invention that the brazing (soldering) paste (224) is omitted, and in its stead, alternating layers of gold and tin in a eutectic ratio are plated onto the interconnection elements (252) prior to mounting the contact tip structures (220) thereto. In a similar manner, eutectic joining layers can be plated onto the contact tip structures (220) prior to joining with the interconnection elements (252).

Since the contact tip structures (220) are readily fabricated to be coplanar and of uniform thickness, the resulting "tipped" interconnection elements **(Figure 2D)** will have tips (i.e., the exposed surfaces of the contact tip structures) which are substantially coplanar.

The electronic component (e.g., 254) to which the interconnection elements (e.g., 252) are mounted may be an ASIC, a microprocessor, a component (e.g., space transformer component) of a probe card assembly, and the like.

### EXAMPLES

It is within the scope of this invention that the techniques disclosed herein can be used to join (e.g., braze) pre-fabricated contact tip structures to interconnection elements which are either resilient or non-resilient, and which are either elongate or not elongate, and which are either composite interconnection elements (such as are disclosed in the PARENT CASE **PCT/US95/14909)** or monolithic interconnection elements, and the like. The interconnection elements to which the contact tip structures are joined may be mounted to (extending from) a substrate such as an electronic component (such as, but not limited to the space transformer of a probe card assembly such as is disclosed in the aforementioned **PCT/US95/14844),** or may be a plurality of interconnection elements which are not mounted to a substrate but which are maintained by some other means in a prescribed spatial relationship to one another.

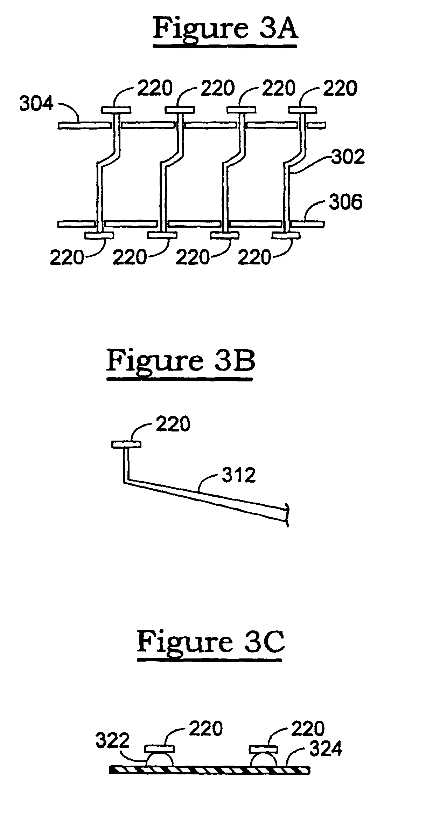

**Figures 3A, 3B and 3C** illustrate a few of such exemplary applications wherein the prefabricated contact tip structures (e.g., 220) of the present invention, are joined to different types of "existing" (fabricated separately) interconnection elements. In these figures, brazing is omitted, for illustrative clarity.

### EXAMPLE 1

An example of a plurality of elongate interconnection elements which are not mounted by their ends to a substrate is the IBM (tm) Cobra (tm) probe which, as shown (stylized) in **Figure 3A**, has a plurality (four of many shown) of elongate interconnection elements 302 extending generally parallel to each other between two rigid fixed planar structures 304 and 306, the two opposite ends of each interconnection element 302 being exposed through a respective one of the two rigid fixed planar structures for making a pressure connection between a terminal (not shown) of a one electronic component (not shown) and a terminal (not shown) of another electronic component (not shown). The illustration of **Figure 3A** is schematic in nature, and is not intended to be a mechanical assembly drawing. The elongate interconnection elements 302 can be kinked, and generally function as buckling beams.

Prefabricated contact tip structures, for example the tip structures 220 shown in **Figure 2B** hereinabove, are readily joined (such as by brazing or plating, discussed hereinabove, not shown) to one end (not shown) or to both ends (as shown) of the interconnection elements 302, as illustrated in **Figure 3A**, after which the sacrificial substrate (e.g., 202) is removed (not shown). For example, if the tip structures 220 are joined to only one end of the interconnection elements, they would preferably be joined to a common (e.g., top, as viewed in the figure) end of the interconnection elements.

This illustrates important advantages of the present invention. The metallurgy, size and topology of the contact tip structures (220) is entirely independent of the physical characteristics of the elongate interconnection elements (302) to which they are joined, as well as being independent of any processes limitations attendant the assembly of such a plurality of interconnection elements into a useful apparatus.

The present invention overcomes problems associated with Cobra-type interconnection elements which require careful shaping of their tips to be effective.

### EXAMPLE 2

**Figure 3B** illustrates a one of a plurality of contact tip structures 220 joined (such as by brazing or plating, discussed hereinabove, not shown) to an end of an elongate tungsten needle 312 which is a typical element of a prior art probe card (not shown).

This illustrates, in an exemplary manner, an important advantage of the present invention. It is generally difficult to provide existing tungsten needles of probe cards with a desired tip shape, especially as the needles are getting smaller and smaller in size (e.g., having a diameter of **1 mil)**. By joining prefabricated contact tip structures (220) to the ends of tungsten needles (312), these problems may be avoided, thereby facilitating the use of ever smaller (e.g., in diameter) tungsten needles while providing contact surfaces (i.e., of the contact tip structures) which are larger (in diameter, or "footprint") than the tungsten needles. The present invention also overcomes, for example, the difficulty in controlling the shape and exact location of the tips (ends) of the tungsten needles.

The present invention overcomes various problems associated with tungsten needle probe elements, including difficulties in grinding their tips to have an appropriate shape and longevity.

In the case of certain interconnection elements, it may be desirable to prepare the surface of the interconnection elements for joining contact tip structures thereto, such as by appropriate plating procedures, to make the surface of the interconnection elements receptive to brazing (or plating). For example, plating tungsten needles (e.g., 312) of a probe card insert with gold, nickel, nickel-palladium, etc. prior to joining contact tip structures (e.g., 220) thereto.

### EXAMPLE 3

The interconnection elements to which the contact tip structures are joined will often be elongate, and may be inherently resilient, such as in the previous two examples. It is, however, within the scope of the present invention that the interconnection elements to which the contact tip structures are joined are neither elongate nor inherently resilient.

**Figure 3C** illustrates a portion of a membrane probe of the type known in the prior art wherein a plurality (two of many shown) of non-resilient bump interconnection elements (contact bumps) 322 are resident on a surface of a flexible membrane 324. As illustrated, the contact tip structures of the present invention, for example the tip structures 220 are joined (such as by brazing or plating, discussed hereinabove, not shown) to the interconnection elements 322. For purposes of this discussion, the rounded bumps 322 are considered to have "tips" or "ends" at their apex (their top edge, as viewed).

The ability to join contact tip structures (220) to the interconnection elements of such membrane probes permits entirely different processes and metallurgies to be employed in the fabrication of the contact tip structures and the bump contacts themselves.

The present invention overcomes problems associated with the semi-spherical contact bumps of membrane probes which cannot generally be reworked.

As will be discussed in greater detail hereinbelow, the present invention also permits a virtually unconstrained desired surface texture to be achieved in the pressure-contacting surface of the tipped interconnection element.

### METALLURGY OF THE CONTACT TIP STRUCTURE

Various metallurgies (metal recipes) for the contact tip structures of the present invention have been described hereinabove. It is within the scope of this invention that any metallurgy suited to the ultimate application of the resulting "tipped" interconnection element be employed.

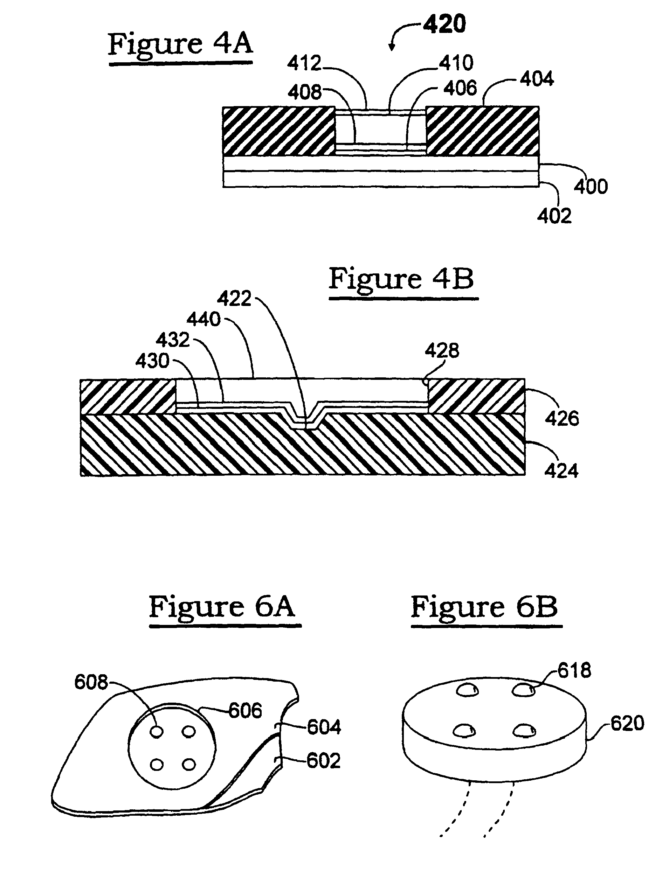

As illustrated in **Figure 4A**, a useful (e.g., preferred) contact tip structure for an interconnection element can be formed in (or on) a sacrificial substrate, in the following manner, using a thin aluminum (foil) as the sacrificial substrate 400:
- provide a temporary backing 402, such as a plastic sheet, for the foil 400, to increase the structural integrity of the foil (this backing layer 402 can also act as a plating barrier/mask);
- pattern the face (top, as viewed) of the foil 400 with a thin (approximately **3 mil)** layer of photoresist 404, or the like, leaving (or creating) openings at locations (compare 212) whereat it is desired to form contact tip structures;
- deposit (such as by plating) a thin (approximately **100 microinch** (µ")) layer 406 of hard gold onto the foil 400, within the openings in the photoresist 404;
- deposit (such as by plating) a very thin (approximately **5-10 µ"**) layer ("strike") of copper 408 onto the layer of hard gold (it should be understood that such a copper strike is somewhat optional, and is provided principally to assist in subsequent plating of the previous gold layer 406);
- deposit (such as by plating) a relatively thick (approximately **2 mil**) layer 410 of nickel onto the copper strike; and
- deposit (such as by plating) a thin (approximately **100 µ"**) layer 412 of soft gold onto the nickel.

This results in a multilayer contact tip structure 420 (compare 220), which is readily joined to an end of an interconnection element (not shown). The contact tip structure 420 has, as its principal layers, a hard gold surface (406) for contacting (e.g., making pressure connections to) electronic components (not shown), a nickel layer (410) providing strength, and a soft gold layer (412) which is readily bonded to (joinable to) an interconnection element.

Regarding depositing the materials (e.g., 214, 216; 406, 408, 410, 412) for the contact tip structure into the openings of the masking material atop the sacrificial substrate, it should be noted that the sacrificial substrate itself (e.g., 400), or one or more of the blanket layers deposited thereon (e.g., 206, 208) serve to electrically connect the openings to one another, thereby facilitating the use of electroplating processes.

### RELEASING THE SACRIFICIAL SUBSTRATE

As mentioned hereinabove, a "plain" (i.e., no active devices resident thereupon) silicon wafer can be used as the sacrificial substrate upon which the contact tip structures of the present invention may be fabricated. An exemplary metallurgy is set forth hereinabove, wherein using a suitable chemical selective etching process, the contact tip structures are released from the sacrificial substrate.

It is within the scope of this invention that an appropriate metallurgy in conjunction with heat can be used to release the sacrificial substrate, rather than a chemical etchant. For example, as illustrated by **Figure 4B:**
Step 1. Etch pits (one of one or more shown) 422 into a silicon (sacrificial) substrate 424 at locations (one of several shown) whereat it is desired to have topological features on contact tip structures. As discussed hereinbelow, etching of silicon can be self-limiting.
Step 2. Apply a patterned masking layer 426 (e.g., photoresist) onto the surface of the silicon (sacrificial) substrate 424. Openings 428 in the masking layer are at locations where the contact tip structures will be fabricated.
Step 3. Deposit (such as by sputtering) a thin layer 430 of a (as will be evident, non-wettable) material such as tungsten (or titanium-tungsten) onto the substrate, within the openings 428 of the masking layer 426.
Step 4. Deposit (such as by sputtering) a thin layer 432 of a non-wetting material such as plateable lead (or indium) onto the thin tungsten layer, within the openings 428 of the mask 426.
Step 5. Fabricate the contact tip structures 440 (compare 220, 420) having one or more layers within the openings of the mask, in the manner described hereinabove (e.g., with respect to **Figure 4A) .**
Step 6. Reflow (using heat) the contact tip structures 440 onto interconnection elements (not shown) in the manner described hereinabove. During reflow, the lead (material 432) will melt and ball up, since tungsten (430) is not wettable with respect to lead (432). This will cause the contact tip structures 440 to be released from the sacrificial substrate 424.

Optionally, a second layer of non-wettable material (e.g., tungsten) can be applied over the layer 432. Said material will become part of the resulting contact tip structure, unless it is removed (e.g., by etching). In some cases, lead will not ball up (e.g., lead tends to wet nickel), in which cases it may be desired to put additional layers such as lead, then tungsten, then lead, to ensure proper release of the contact tip structures from the sacrificial substrate.

Optionally, another layer of material which will ball up when heated (e.g., lead, indium) can be applied over the second layer of non-wettable material (e.g., tungsten). Any residual lead on the surface of the resulting contact tip structure is readily removed, or may be left in place. Alternatively, a layer of a "barrier" material can be deposited between the second layer of material which will ball up and the first layer (e.g., rhodium) of the fabricated contact tip structure 1420. The "barrier" material may be tungsten, silicon nitride, molybdenum, or the like.

### TIP TOPOLOGY (Surface Topography)

In the main hereinabove, contact tip structures (e.g., 102, 220, 440) which have a flat contact surface have been discussed. For many pressure contact applications, a spherical **or very small surface area** contact tip urging against a nominally flat-surfaced terminal of an electronic component is preferred. In other applications, the surface of the contact tip structure will preferably have projections in the shape of a pyramid, a truncated pyramid, a cone, a wedge, or the like.

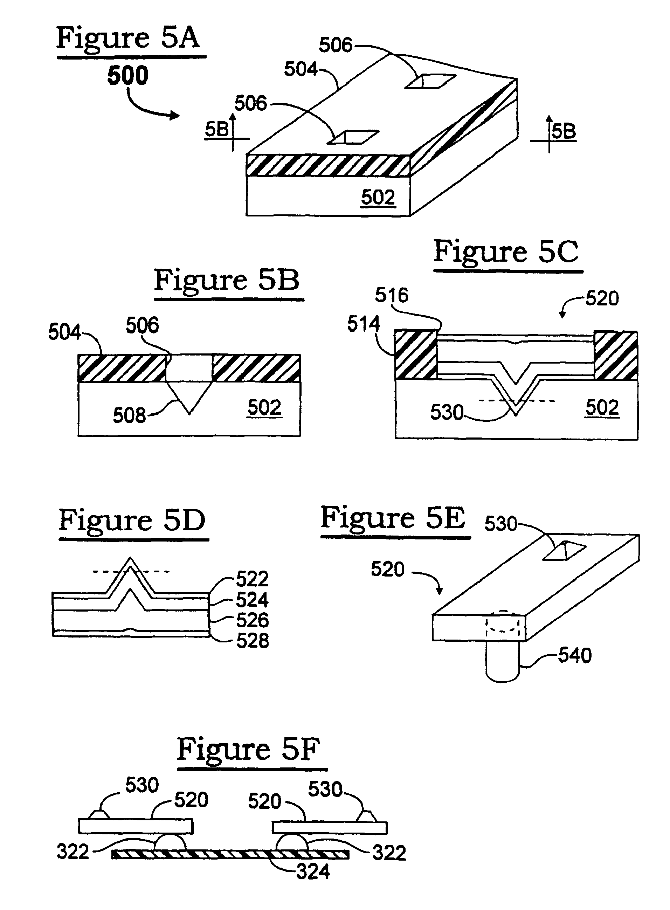

**Figure 5A** illustrates a first step in a technique 500 for forming elongate contact tip structures having pyramid or truncated pyramid contact features on a sacrificial substrate 502 which is a silicon wafer. A layer 504 of masking material, such as photoresist, is applied to the surface of the silicon substrate 502, and is patterned to have a plurality (two of many shown) of openings 506 extending to the surface of the silicon substrate 502. The openings 506 are preferably square, measuring approximately **1-4 mils**, such as **2.5 mils** on a side. However, the openings may be rectangular, or may have other geometric shapes.

Next, as illustrated in **Figure 5B,** the silicon substrate 502 is etched to form a like plurality (one of many shown) of pyramid-shaped depressions 508 in the silicon. Such etching of silicon will tend to be self-limiting, as the etching proceeds along the crystal plane at **54.74°** for (100) silicon. In other words, the depression will extend to a depth which is defined (dictated) by the size of the opening (506) and the nature of the silicon substrate (502). For example, with square openings **2.5 mils** per side, the depth of the depression will be approximately **2 mils.** Ultimately, these depressions 508 will become contact features integrally formed upon the resulting contact tip structure to be formed on the silicon substrate. This is preferably a photolithographic process, so that the size and spacing of the openings (506) and features (508) will be extremely precise, to tolerances of microns (10⁻⁶ meters).

Next, as illustrated in **Figure 5C,** the masking material 504 is removed, and a new masking layer 514 (compare 504), such as photoresist, is applied to the surface of the silicon substrate 502 and is patterned to have a plurality (one of many shown) of openings 516 (compare 506) extending to the surface of the silicon substrate 502. The openings 516 are larger than the openings 506, and are aligned therewith. (Each opening 516 is over a depression 508.) An exemplary opening 516 is a rectangle suitably measuring approximately **7 mils** (across the page, as shown) by **8-30 mils** (into the page, as shown). Ultimately, these openings depressions 516 will be filled with conductive material forming the body of the contact tip structures being pre-fabricated on the sacrificial substrate 502. This is also preferably a photolithographic process, but the size and spacing of these openings 516 need not be as precise as previous openings 506, and tolerances on the order of up to **1 mil** (0.001 inch) are generally acceptable.

Next, as illustrated by **Figure 5C,** a plurality (one of many shown) of multilayer contact tip structures 520 (compare 220, 420) is built up within the openings 516, each of which has a pyramid-shaped feature 530 extending from a surface thereof. In this example, the multilayer buildup is suitably:
- first deposit (apply) a release mechanism 522 such as has been described hereinabove (e.g., a multilayer buildup of lead/tungsten/lead);
- then deposit a relatively thin layer 524 of rhodium or tungsten (or ruthenium, or iridium, or hard nickel or cobalt or their alloys, or tungsten carbide), such as **0.1 - 1.0 mils** thick;
- then deposit a relatively thick layer 526 of nickel, cobalt or their alloys;
- finally deposit a relatively thin layer 528 of soft gold, which is readily brazed to.

In this manner, a plurality of elongate contact tip structures 520, each having a projecting pyramid-shaped contact feature 530 projecting from a surface thereof. It is this projecting contact feature that is intended to make the actual contact with a terminal (not shown) of an electronic component (not shown).

As shown in **Figures 5D, 5E and 5F,** the pyramid-shaped contact feature 530 is suitably polished (abraded) off, along the line 524, which will configure the pyramid-shaped feature as a truncated pyramid-shaped feature. The relatively small flat end shape (e.g., a square measuring a few tenths of a mil on a side), rather than a truly pointed end shape, will tend to be sufficiently "sharp" to make reliable pressure connections with terminals (not shown) of electronic components (not shown), and will tend to wear better than a truly pointed feature for making repeated (e.g., thousands of) pressure connections to a large number of electronic components, such as would be expected in an application of the tipped interconnection elements of the present invention for probing (e.g., **silicon device wafers).**

Another advantage of polishing off the point of the contact feature 530 is that the second layer of the multilayer buildup can be exposed for making contact with a terminal (not shown) of an electronic component (not shown). For example, this layer can be of a material with superior electrical characteristics, such as **rhodium.** Or, it can be a material with superior wear characteristics, such as **titanium-tungsten.**

**Figure 5E** illustrates the elongate contact tip structure 520 of the present invention joined to an end of an elongate interconnection element 540 (compare 302). **Figure 5F** illustrates the elongate contact tip structures 520 of the present invention joined to a contact bump 322 of a membrane probe 324 (compare **Figure 3C).** In these exemplary applications, the contact tip structures 520 having projecting topological contact features 530 provide:
- a distinct metallurgy;
- a distinct contact topology (topography);
- tightly controlled positional tolerances; and
- if desired, a degree of pitch spreading.

Regarding effecting pitch spreading, it can be seen in **Figure 5F** that the contact tip structures can be arranged so that the spacing between the contact features 530 is greater (as shown) or lesser (not shown) than the spacing of the contact balls 322.

Generally, in use, the "tipped" interconnection element is mounted to a first electronic component, and the apex (top, as viewed in **Figures 5E and 5F)** portion of the pyramid effects an electrical connection to a terminal (not shown) of a second electronic component (not shown).

As mentioned above, by prefabricating contact tip structures (e.g., 520) with topological contact features (e.g., 530) on a surface thereof, it is possible to achieve extremely high positional precision for the pressure connection to be made, without requiring a comparable degree of precision in either the body portion of the contact tip structure or the interconnection element to which it is joined. By way of analogy, picture (in your mind) a golf course. A cup (hole) is precisely located on the green. A player is standing somewhere (anywhere) on the green. The cup, which is precisely located and of extremely precise dimensions (i.e., fractions of an inch), is analogous to the topological contact feature (e.g., 530). The green, which extends around the cup to coarse tolerances (i.e., feet or yards), is analogous to the body portion of the contact tip structure (e.g., 520). The player, who is standing somewhere (i.e., anywhere) on the green (the player's feet are the end of the interconnection element), is analogous to the interconnection element (e.g., 540) to which the contact tip structure is joined. In other words, the topological contact feature provides extreme precision to what can be relatively very sloppy positioning of the end of the interconnection element. Thus it can be seen that by providing each of a plurality of roughly positioned contact tip structures with a contact feature which is precisely located with respect to topological contact features on other ones of the plurality of contact tip structures, precisely positioned connections can be made to terminals of electronic components.

### AN ALTERNATE TIP TOPOLOGY

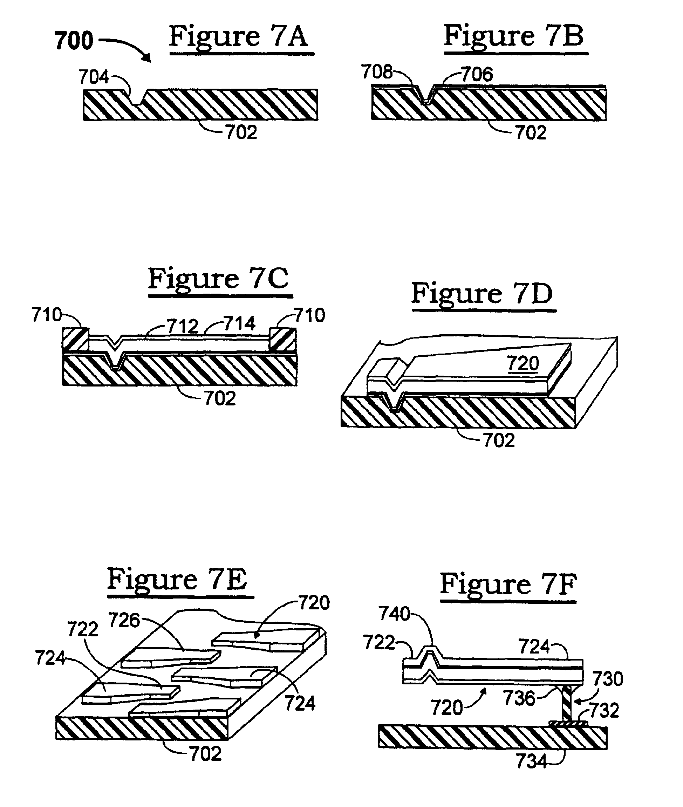

**Figures 6A and 6B** illustrate an embodiment of providing contact tip structures with topological contact features. In this example, a sacrificial substrate 602 has a masking layer 604 with a plurality (one of many shown) of openings 606. The surface of the sacrificial substrate (in this example, the sacrificial substrate is aluminum) is "prepared" for contact tip fabrication by urging a pointed tool down (into the page, as viewed) against the surface of the substrate, resulting in one or more, including three or more, preferably four (as illustrated) dimples (depressions) 608 being formed in the surface of the sacrificial substrate 602.

In subsequent processing steps wherein a contact tip structure is fabricated (such as has been described hereinabove), these depressions 608 will "mirror" themselves as one or more (four shown) "dimple" contact features 618 projecting from the main body of the resulting contact tip structure 620 (compare 102, 220, 420). As is known, three-legged chairs are more stable than four-legged chairs. Thus, although it might seem that having exactly three projecting features (618) would be preferred, by having four projecting features 618, preferably arranged evenly-spaced (like the corners of a square), one is virtually assured that when the contact tip structure 620 is urged against a corresponding flat-surfaced terminal (not shown) of an electronic component (not shown), the contact tip structure 620 will be permitted to "rock" back and forth (i.e., on two diagonally-opposed features 618) to pierce through oxidation and the like on the terminal, thereby effecting a reliable electrical pressure connection between the "tipped" interconnection element and the terminal. This is desirable for effecting pressure connections in certain applications.

### AN ALTERNATE TIP METALLURGY

The desirability of fabricating multilayer tip structures and various tip metallurgies have been discussed hereinabove.

It is within the scope of this invention that the tip metallurgy is as follows: Starting with a silicon sacrificial substrate:
Step 1. first deposit a layer of aluminum;
Step 2. then deposit a layer of chrome;
Step 3. then deposit a layer of copper; and
Step 4. then deposit a layer of gold.

The resulting tip contact structure will have an aluminum contact surface (Step 1) and a gold surface (Step 4) for facilitating brazing (or the like) to an interconnection element. The aluminum contact surface is ideal for making a pressure connection to an LCD panel, preferably a socketable connection using external instrumentalities (e.g., spring clips and the like) to hold the electronic component having the interconnection elements with the aforementioned tip structures to the LCD panel.

As an aid to visualizing the multilayer contact tip structure of this or any other embodiment described herein, attention is directed to the illustration of **Figures 2A and 4A**.

### ELONGATE CONTACT TIP STRUCTURES

It has been described hereinabove how sacrificial substrates can be employed to:
(a) prefabricate contact tip structures for subsequent attachment (joining) to tips (ends) of elongate interconnection elements (such as, but not limited to, composite interconnection elements), as well as to other types of interconnection elements (such as bump elements of membrane probes); and
(b) prefabricate contact tip structures upon which interconnection elements can directly be fabricated for subsequent mounting as "tipped" interconnection elements to terminals of electronic components.

It will now be described how the contact tip structures themselves can function as interconnection elements, without requiring that they be joined to other existing interconnection elements. As will be described in greater detail hereinbelow, these contact tip structures which, in and of themselves, can function as spring contact elements, are generally elongate, and will still be referred to as "contact tip structures".

**Figures 7A-7F** illustrate a technique 700 for fabricating contact tip structures which are elongate and which, in use, will function as cantilever (plated cantilevered beam) spring contact elements, and mounting same to terminals of electronic components. These techniques are particularly well suited to ultimately mounting spring contact elements to electronic components such as semiconductor devices, space transformer substrates of probe card assemblies, and the like.

**Figure 7A** illustrates a sacrificial substrate 702 such as a silicon wafer, into a surface of which a plurality (one of many shown) trenches 704 are etched. The trenches 704 are illustrative of any surface texture 'template' for the contact tip structures which will be fabricated on the sacrificial substrate 702. (Compare the topological contact features described hereinabove.) The layout (spacing and arrangement) of the trenches 704 can be derived from (replicate; i.e., "mirror") the bond pad layout of a semiconductor die (not shown) which is ultimately (in use) intended to be contacted (e.g., probed). For example, the trenches 704 can be arranged in a row, single file, down the center of the sacrificial substrate. Many memory chips, for example, are fabricated with a central row of bond pads.

**Figure 7B** illustrates that a hard "field" layer 706 has been deposited upon the surface of the sacrificial substrate 702, including into the trenches 704. Another layer 708, such as of a plateable material, can optionally be deposited over the field layer 706, if the field layer is of a material which is not amenable to plating such as tungsten-silicide, tungsten, or diamond. (If, as will be evident from the discussion hereinbelow, the layer 706 is difficult to remove, it may be applied by selective deposition (e.g., patterning through a mask), to avoid such removal.)

In a next step, illustrated by **Figure 7C,** a masking material 710, such as photoresist, is applied to define a plurality of openings for the fabrication of plated cantilever tip structures. The openings in the masking layer 710 extend to over the trenches 704. Next, a relatively thick (e.g., **1-3 mils**) layer 712 of a spring alloy material (such as nickel and its alloys) is optionally deposited (such as by plating), over which a layer 714 of material is deposited which is amenable to brazing or soldering, in the event that the spring alloy is not easy to bond, solder or braze to. The spring alloy layer 712 is deposited by any suitable means such as plating, sputtering or CVD.

Next, as illustrated by **Figures 7D and 7E,** the masking material 710 is stripped (removed), along with that portion of the layers (706 and 708) which underlies the masking material 710, resulting in a plurality (one of many shown) of elongate contact tip structures 720 having been fabricated upon the sacrificial substrate 702. Each elongate contact tip structure 720 has an inner end portion 722 (directly over a corresponding one of the trenches 704), an outer end portion 724, and an intermediate portion 726 between the inner and outer end portions 722 and 724.

As is best viewed in **Figure 7E,** the cantilever tip structures 720 may be staggered (oriented left-right-left-right), so that although their inner end portions 722 are all aligned in a row (corresponding, e.g., to a central row of bond pads on a semiconductor device), with their outer end portions 724 oriented opposite one another. In this manner, the spacing between the outer end portions 724 of the contact tip structures 720 is at a greater (coarser) pitch (spacing) than the inner end portions 722.

Another feature of the cantilever tip structure 720 of the present invention is that the intermediate portion 726 can be tapered, as best viewed in **Figure 7E,** from narrowest at the inner (contact) end portion 722 to widest at the outer (base) end portion 724. This feature provides for controllable, determinate amount of deflection of the inner end portion 722 when the outer end portion 724 is rigidly mounted to a terminal of an electronic component such as a space transformer of a probe card assembly or a bond pad of a semiconductor device. Generally, deflection will be localized at or near the inner (contact) ends of the contact tip structures.

**Figure 7F** illustrates the mounting of the cantilever tip structures 720 fabricated according to the technique 700 of **Figures 7A-7E** to rigid "pedestals" 730 extending (e.g., free-standing) from corresponding terminals (one of many shown) 732 of an electronic component 734. Generally, the function of the pedestal 730 is simply to elevate the contact tip structure 720 in the z-axis, above the surface of the component 734, so that there is room for the contact end 722 to deflect (downwards, as viewed) when making a pressure connection to a terminal (not shown) of an electronic component (not shown). It is within the scope of this invention that the pedestal (730) itself may be resilient, in which case the elongate contact tip structure (720) may or may not also be resilient, as desired for a specific application (use).

As illustrated, the pre-fabricated elongate tip structures 720 are mounted by their outer (base) end portions 724 to the ends (top, as shown) of the pedestals 730, in any suitable manner such as by brazing or soldering. Here, another advantage of the outer end portions being the widest portion of the cantilever tip structure 720 is evident, the large outer end portion of the elongate contact tip structure providing a relatively large surface area for performing such soldering or brazing, which is shown by the fillet structure 736, affording the opportunity to securely join the outer (base) end of the elongate contact structure to the pedestal.

It is within the scope of this invention that the pedestal 730 can be any free-standing interconnection element including, but not limited to, composite interconnection elements, and specifically including contact bumps of probe membranes (in which case the electronic component 734 would be a probe membrane) and tungsten needles of conventional probe cards.

As best viewed in **Figure 7F,** the contact end portion (722) of the elongate contact tip structure (720) is provided with a raised feature 740 which, in use, effects the actual pressure connection to the terminal (not shown) of the electronic component (not shown). The shape and size of this feature 740 is controlled by the shape and size of the trench 704 (see **Figure 7A).**

In any cantilever beam arrangement, it is preferred that a one end of the cantilever be "fixed" and the other end "movable". In this manner, bending moments are readily calculated. Hence, it is evident that the pedestal (730) is preferably as rigid as possible. In the case of the elongate contact structure (720) being joined to a contact bump on a membrane probe, much resilience and/or compliance will be provided by the membrane (734), per se. In certain applications, it is desirable that the pedestal (730) would be implemented as a "composite interconnection element" (refer to the aforementioned **PCT/US95/14909)** which will contribute to the overall deflection of the contact ends of the elongate contact tip structures in response to pressure connections being made thereto.

### EFFECTING PITCH-SPREADING WITH THE CONTACT TIP STRUCTURES

In the previous example (see **Figure 7E),** the contact tip structures (720) are arranged to have alternating orientations (left-right-left-right) so that their inner (contact) ends are at a first pitch and their outer (base) ends are at a second pitch which is greater (coarser) than the first pitch. A "pitch-spreading" effect can be achieved by fabricating the contact tip structures so as to have alternating lengths.

**Figure 8** illustrates another technique 800 for effecting pitch-spreading with the contact tip structures (as opposed to, or in addition to, pitch-spreading which may be effected by a space transformer to which the contact tip structures are mounted).

In this example 800, a plurality (five of many shown) of elongate contact tip structures 820a..820e (collectively referred to as "820", compare 720) have been formed on a sacrificial substrate 802 (compare 702). Each contact tip structure 820 has an inner (contact) end 822 (822a..822e) and an outer (base) end 824 (824a..824e). In this figure, it can be observed that the inner ends 822 are aligned along a line labelled "R", and that the contact tip structures 820 are all disposed (oriented, extend) in the same direction (to the right, as viewed in the figure).

According to the invention, the elongate contact tip structures 820 have different lengths than one another and are arranged in an alternating manner such as long-short-long-short-long, so that their outer (base) ends 824a..824e have a greater pitch than their inner (contact) ends 822a..822e.

In use, the elongate contact tip structures 820 are readily mounted by their base ends 824 to terminals of an electronic component, in any suitable manner described hereinabove.

### ANOTHER ELONGATE CONTACT TIP STRUCTURE

It has been described, hereinabove, how elongate cantilever contact tip structures (e.g., 720, 820) can be fabricated on sacrificial substrates using conventional semiconductor fabricating processes (including micromachining) such as masking, etching and plating, and how the resulting elongate cantilever contact tip structures can be provided with nonplanar (out-of-plane) "raised" features (e.g., 740). In other words, as will be evident, the shape of the resulting elongate cantilever contact tip structure can readily be controlled in all three (x,y,z) axes.

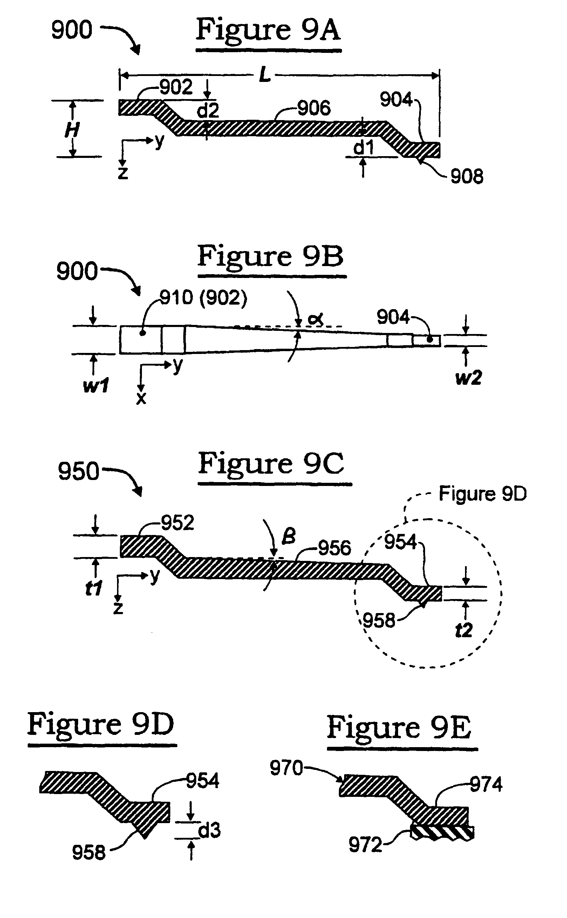

**Figures 9A-9E** illustrate alternate embodiments for elongate cantilever contact tip structures, and correspond to Figures 1A-1E of the aforementioned U.S. Provisional Patent Application No. 60/034,053 filed 12/31/96.

**Figures 9A and 9B** illustrate an elongate contact tip structure (spring contact element) 900 that is suitable for attachment as a free-standing structure to an electronic component including, but not limited to, the space transformer of the aforementioned **PCT/US95/14844.**

The structure 900 is elongate, has two ends 902 and 904, and has an overall longitudinal length of "L" between the two ends. By way of example, the length "L" is in the range of **10-1000 mils**, such as **40-500 mils** or **40-250 mils**, preferably **60-100 mils**. As will become apparent from the discussion that follows, in use the structure has an "effective" length of "L1", which is less than "L", which is the length over which the structure 900 can flex in response to a force applied thereto.

The end 902 is a "base" whereat the contact element 900 will be mounted to an electronic component (not shown) . The end 904 is a "free-end" (tip) which will effect a pressure connection with another electronic component (e.g., a device-under-test, not shown).

The structure 900 has an overall height of "H". By way of example, the height "H" is in the range of **4-40 mils,** preferably **5-12 mils.** (1 mil = 0.001 inches)

As best viewed in **Figure 9A**, the structure 900 is "stepped". The base portion 902 is at a first height, the tip 904 is at another height, and a middle (central) portion 906 is at a third height which is between the first and second heights. Therefore, the structure 900 has two "standoff" heights, labelled **"d1"** and **"d2"** in the figure. In other words, the spring contact element 900 has two "steps", a step up from the contact end 904 to the central body portion 906, and a further step up from the central body portion 906 to the base end 902.

In use, the standoff height "d1", which is the "vertical" (as viewed in **Figure 9A)** distance between the contact end 904 and the central portion 906, performs the function of preventing bumping of the structure with the surface the electronic component (not shown) when deflecting in response to making a pressure connection with a terminal (not shown) of the electronic component (not shown).

In use, the standoff height "d2", which is the "vertical" (as viewed in **Figure 9A)** distance between the base end 902 and the central portion 906, performs the function of allowing the beam to bend through the desired overtravel, without contacting the surface of the substrate (including an electronic component) to which the elongate contact structure 900 is mounted.

By way of example, the dimensions for the standoff heights "d1" and "d2" are:
- "d1" is in the range of **3-15 mils**, preferably approximately **7 mils + 1 mil**; and
- "d2" is in the range of **0-15 mils**, preferably approximately **7 mils + 1 mil**. In the case of "d2" being **0 mil**, the structure would be substantially planar (without the illustrated step) between the central portion 906 and the base portion 902.

As best viewed in **Figure 9B,** the structure 900 is may be provided with a distinct "joining feature" 910 at its base end 902. The joining feature may be a tab or, optionally a stud, which is used to facilitate brazing the probe structure to a substrate (e.g., a space transformer or a semiconductor device) during assembly therewith. Alternatively, the component or substrate to which the structure 900 is mounted may be provided with a stud (pedestal, compare 730) or the like to which the base portion 902 is mounted.

In use, the structure 900 is intended to function as a cantilever beam, and is preferably provided with at least one taper angle, labelled "**α**" in **Figure 9B.** By way of example, the width "**w1**" of the structure 900 at its base end 902 is in the range of **3-20 mils**, preferably **8-12 mils**, and the width "w2" of the structure 900 at its tip end 904 in the range of **1-10 mils**, preferably **2-8 mils**, and the taper angle **"α"** is preferably in the range of **2-6 degrees.** The narrowing of (taper) the structure 900, from its base 902 to its tip 904, permits controlled flexure and more even stress distribution (versus concentration) of the structure 900 when its base 902 is secured (immovable) and a force is applied at its tip (904). The width of the structure (hence, the taper angle "**α**") is readily controlled employing well-known lithographic techniques.

The tip end 904 of the structure 900 is preferably provided with a topological feature 908, for example in the geometric form of a pyramid, to aid in effecting pressure connection to a terminal of an electronic component (not shown).

As illustrated in **Figures 9A and 9B**, the spring contact element 900 is three-dimensional, extending in the x- y- and z-axes. Its length **"L"** is along the y-axis, its widths **("w1"** and **"w2")** are along the x-axis, and its thicknesses **("t1"** and **"t2")** and height **("H")** are along the z-axis. When the spring contact element 900 is mounted to an electronic component, it will be mounted thereto so that the length and width of the spring contact element are parallel to the surface of the electronic component, and its height is normal to the surface of the electronic component.

**Figure 9C** illustrates a spring contact structure 950 similar in most respects to the structure 900 of **Figures 9A and 9B**. The structure is elongate, has a base end 952 (compare 902) and a contact end 954 (compare 904), and a topological feature 958 (compare 908) disposed at contact end 954. The principal difference being illustrated in **Figure 9C** is that the structure 950 can be provided with a second, z-axis, taper angle "**β**".

For example, as best viewed in **Figure 9C,** the thickness "**t1**" of the structure 950 at its base end 952 is in the range of **1-10 mils**, preferably **2-5 mils**, and the thickness "**t2**" of the structure 950 at its contact end 954 in the range of **1-10 mils**, preferably **1-5 mils**, and the taper angle "**ß**" is preferably in the range of **2-6 degrees**.

The angle "ß" (**Figure 9C**) may be created using various methods for controlling the thickness distribution. For example, if the structure 950 is formed by plating, a suitable plating shield can be incorporated into the bath. If the structure 950 is formed other than by plating, appropriate known processes for controlling the spatial distribution of thickness of the resulting structure would be employed. For example, sandblasting or electro-discharge machining (EDM) the structure 950.

Thus, an elongate contact structure can be formed which has a composite (dual) taper from its base end (902, 952) to its contact end (904, 954). It may have a taper angle "α" which will be parallel to the x-y plane of the substrate or component to which the elongate contact structure is mounted. And it may have a taper angle "**β**" which represents a narrowing of the structure's thickness (z-axis). Both tapers represent a diminishing of the structure's (900, 950) cross-section from larger at its base end (902, 950) to smaller at its contact end (904, 954).

It is within the scope of this invention that the structure is not tapered in width, in which case the taper angle **"α"** would be ZERO. It is also within the scope of this invention that the taper angle "α" is greater than 2-6 degrees, for example as much as **30 degrees**. It is within the scope of this invention that the structure is not tapered in thickness, in which case the taper angle **"β"** would be ZERO. It is also within the scope of this invention that the taper angle **"β"** is greater than **2-6 degrees,** for example as much as **30 degrees.** It is within the scope of this invention that the structure is tapered only in thickness and not in width, or only in width and not in thickness.

The contact structures 900 and 950 are principally, preferably entirely, metallic, and may be formed (fabricated) as multilayer structures, as has been described hereinabove.

**Figure 9D** shows an enlarged view of the contact end 954 of the contact structure 950 (equally applicable to the contact ends of other contact structures illustrated herein). In this enlarged view it can be seen that the contact feature 954 is suitably quite prominent, projecting a distance **"d3",** in the range of **0.25-5 mils**, preferably **3 mils** from the bottom (as viewed) surface of the contact end of the spring contact element, and is suitably in the geometric shape of a pyramid, wedge, a hemisphere, or the like.

The resulting spring contact element has an overall height **"H"** which is the sum of **"d1", "d2"** (and **"d3")** plus the thickness of the central body portion.

There has thus been described a exemplary spring contact element suitable for effecting connections between two electronic components, typically being mounted by its base end to a one of the two electronic components and effecting a pressure connection with its contact end to an other of the two electronic components, having the following dimensions (in mils, unless otherwise specified):

| dimension | range | preferred |
|---|---|---|
| L | 10-1000 | 60-100 |
| H | 4-40 | 5-12 |
| d1 | 3-15 | 7±1 |
| d2 | 0-15 | 7±1 |
| d3 | 0.25-5 | 3 |
| w1 | 3-20 | 8-12 |
| w2 | 1-10 | 2-8 |
| t1 | 1-10 | 2-5 |
| t2 | 1-10 | 1-5 |
| α | 0-30° | 2-6° |
| β | 0-30° | 2-6° |

from which the following general relationships are evident:
**"L"** is approximately at least 5 times **"H";**
**"d1"** is a small fraction of **"H",** such as between one-fifth and one-half the size of **"H";**
**"w2"** is approximately one-half the size of **"w1",** and is a small fraction of **"H",** such as between one-tenth and one-half the size of **"H";** and
"**t2**" is approximately one-half the size of "**t1**".

**Figure 9E** illustrates an alternate embodiment of the invention wherein discrete contact tip structures 972 (compare 220) can be joined to the contact ends 974 of elongate contact tip structures 970 (compare 900, 950), in lieu of providing the contact ends with integrally-formed raised contact features (908, 958). This provides the possibility of the contact tip structure 968 having a different metallurgy, than the elongate contact tip structures (spring contact elements) 970. For example, the metallurgy of the spring contact element 970 is suitably targeted at its mechanical (e.g., resilient, spring) characteristics and its general capability to conduct electricity, while the metallurgy of a contact tip structure 972 mounted thereto is appropriately targeted to making superior electrical connection with a terminal (not shown) of an electronic component (not shown) being contacted and, if needed, can have superior wear-resistance.

### MATERIALS AND PROCESSES

Suitable materials for the one or more layers of the contact tip structures described herein include, but are not limited to:
nickel, and its alloys;
copper, cobalt, iron, and their alloys;
gold (especially hard gold) and silver, both of which exhibit excellent current-carrying capabilities and good contact resistance characteristics;
elements of the platinum group;
noble metals;
semi-noble metals and their alloys, particularly elements of the palladium group and their alloys; and
tungsten, molybdenum and other refractory metals and their alloys.

In cases where a solder-like finish is desired, tin, lead, bismuth, indium and their alloys can also be used.

Suitable processes for depositing these materials (e.g., into openings in a masking layer on a sacrificial substrate) include, but are not limited to: various processes involving deposition of materials out of aqueous solutions; electrolytic plating; electroless plating; chemical vapor deposition (CVD); physical vapor deposition (PVD); processes causing the deposition of materials through induced disintegration of liquid or solid precursors; and the like, all of these techniques for depositing materials being generally well known. Electroplating is a generally preferred technique.

### TAILORING (UNIFORMIZING) "K"

A plurality of elongate contact tip structures having different lengths (all other parameters such as materials and cross-section being equal) will exhibit different resistance to contact forces applied at their free (contact) ends. It is generally desirable that the spring constants "K" for all of the elongate contact tip structures mounted to a given electronic component be uniform.

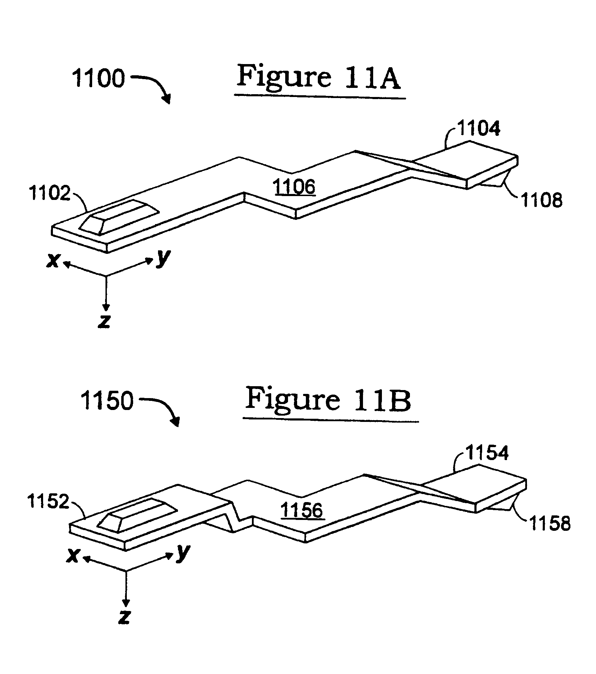

**Figures 10A-10D** illustrate elongate contact tip structures (1000, 1020, 1040, 1060) mounted to electronic components (1010, 1030, 1050, 1070, respectively), and techniques for tailoring the resistances "K" of a plurality of otherwise non-uniform elongate contact tip structures to be uniform, and correspond to Figures 7A-7D of the aforementioned U.S. Provisional Patent Application No. **60/034,053** filed 12/31/96.

The elongate contact tip elements (1000, 1020, 1040, 1060) are similar to any of the elongate contact tip structures described hereinabove, and have a base end (1002, 1022, 1042, 1062) offset in a one direction from a central body portion (1006, 1026, 1046, 1066, respectively) and a tip portion (1004, 1024, 1044, 1064) offset in an opposite direction from the central body portion. Compare the elongate contact tip structures 900 and 950 of **Figures 9A and 9C**, respectively.

**Figure 10A** illustrates a first technique for tailoring spring constant. In this example, a spring contact element 1000 (compare any of the elongate contact tip structures described hereinabove) is mounted by its base end 1002 to a terminal of an electronic component 1010. A trench 1012 is formed in the surface of the electronic component 1010 and extends from under the contact end 1004 of the spring contact structure 1000, along the body portion 1006 thereof, towards the base end 1002 of the spring contact element 1000 to a position (point) "**P**" which is located a prescribed, fixed distance, such as **60 mils** from the contact end 1004. When a force is applied downwards to the contact end 1004, it is intended that the spring contact element 1000 will bend (deflect) until the body portion 1006 contacts the edge of the trench 1012 (i.e., the surface of the component 1010) at the point **"P",** whereupon only the outermost portion (from the point **"P"** to the end 804) of the spring contact element 1000 is permitted to further deflect. The outermost portion of the spring contact element has an 'effective' controlled length of **"L1",** which can readily be made the same for any number of spring contact elements (1000) having an overall length **"L"** which is greater than **"L1".** In this manner, the reaction ("K") to applied contact forces can be made uniform among spring contact elements of various lengths (so long as the point **"P"** falls somewhere within the central body portion of the spring contact element).

**Figure 10B** illustrates another technique for tailoring spring constant. In this example, a spring contact element 1020 is mounted by its base end 1022 to an electronic component 1030 (compare 1010). A structure 1032 (compare 1012) is formed on the surface of the electronic component 1030 at a location between the base end 1022 of the spring contact structure 820, between the surface of the electronic component 1030 and the central body portion 1026 (compare 1006) of the spring contact structure 1020 and extends along the body portion 1026 (compare 1006) thereof, towards the contact end 1024 (compare 1004) of the spring contact element 1020 to a position (point) "P" which is located a prescribed, fixed distance, such as the aforementioned (with respect to **Figure 10A)** prescribed distance, from the contact end 1024. The structure 1032 is suitably a bead of any hard material, such as glass or a pre-cut ceramic ring, disposed on the surface of the electronic component 1030. When a force is applied downwards to the contact end 1024, only the outermost portion (from the point "P" to the end 1024) of the spring contact element 1020 is permitted to deflect. As in the previous embodiment (1000), in this manner the reactions to applied contact forces can be made uniform among spring contact elements of various lengths.

**Figure 10C** illustrates yet another technique for tailoring spring constant. In this example, a spring contact element 1040 (compare 1000 and 1020) is mounted by its base end 1042 to an electronic component 1050. An encapsulating structure 1052 is formed on the surface of the electronic component 1050 in a manner similar to the structure 1032 of the previous embodiment. However, in this case, the structure 1052 fully encapsulates the base end 1042 of the spring contact structure 1040 and extends along the body portion 1046 thereof, towards the contact end 1044 thereof, to a position (point) **"P"** which is located a prescribed, fixed distance, such as the aforementioned (with respect to **Figure 10B)** prescribed distance, from the contact end 1044. The outermost portion of the spring contact element 1040 has an 'effective' length of **"L1".** As in the previous embodiments, when a force is applied downwards to the contact end 1044, only the outermost portion (from the point "P" to the end 1044) of the spring contact element 1044 is permitted to deflect. As in the previous embodiments, the reactions to applied contact forces can be made uniform among spring contact elements of various lengths.

**Figure 10D** illustrates yet another technique for tailoring spring constant. In this example, a spring contact element 1060 (compare 1000, 1020, 1040) is mounted by its base end 1062 to an electronic component 1080 (compare 1050). In this example, the body portion 1066 is formed with a "kink" 1072 at a position (point) "P" which is located a prescribed, fixed distance, such as the aforementioned (with respect to **Figure 8C)** prescribed distance, from the contact end 1064. The outermost portion of the spring contact element 1060 thus has an 'effective' length of "L1". As in the previous embodiments, when a force is applied downwards to the contact end 1064, only the outermost portion (from the point "P" to the end 1064) of the spring contact element 1060 is permitted to deflect. (The kink 1072 can be sized and shaped so that the entire contact structure 1060 deflects slightly before the kink 1072 contacts the surface of the component 1070, after which only the outermost portion of the spring element 1060 will continue to deflect.) As in the previous embodiments, the reactions to applied contact forces can be made uniform among spring contact elements of various lengths.

It is within the scope of this invention that other techniques can be employed to "uniformize" the spring constants among contact elements having different overall lengths ("L"). For example, their widths and or "**α**" taper can specifically be made to be different from one another to achieve this desired result.

### THREE-DIMENSIONAL ELONGATE CONTACT TIP STRUCTURES

There have been described hereinabove a number of elongate contact tip structures which are suitable to be mounted directly to, or fabricated upon, terminals of electronic components, and which are capable of extending "three-dimensionally" from the electronic component so that contact ends thereof are positioned to make pressure connections with terminals of another electronic component.

**Figures 11A and 11B** illustrate another embodiment of elongate contact tip structures which are suited to function, in and of themselves, as spring contact elements. **Figures 11A and 11B** are comparable to Figures 8A-8B of the aforementioned U.S. Provisional Patent Application No. **60/034,053,** filed 12/31/96.

**Figure 11A** illustrates a spring contact element 1100 that has been fabricated according to the techniques set forth hereinabove, with the exception (noticeable difference) that the central body portion 1106 (compare 906) of the contact element is not straight, Although it may still lay in a plane (e.g., the x-y plane), it is illustrated as "jogging" along the x-axis while traversing the y-axis, in which case the base end 1102 (compare 902) will have a different x-coordinate than the contact end 1104 (compare 904) or the contact feature 1108 (compare 908) disposed at the contact end 1104.

**Figure 11B** illustrates another spring contact element 1150 that is similar in many respects to the spring contact element 1100 of **Figure 11A,** with the exception that there is a z-axis step between the central body portion 1156 (compare 1106) and the base portion 1152 (compare 1102) in addition to the step between the central portion 1156 and the contact end portion 1154 (compare 1104). The spring contact element 1150 is illustrated with a contact feature 1158 (compare 1108) at its contact end 1154.

Although the invention has been illustrated and described in detail in the drawings and foregoing description, the same is to be considered as illustrative and not restrictive in character - it being understood that only preferred embodiments have been shown and described, and that all changes and modifications that come within the spirit of the invention are desired to be protected. Undoubtedly, many other "variations" on the "themes" set forth hereinabove will occur to one having ordinary skill in the art to which the present invention most nearly pertains, and such variations are intended to be within the scope of the invention, as disclosed herein.

For example, the resulting elongate contact tip structures and spring contact elements may be heat-treated to enhance their mechanical characteristics, either while they are resident upon the sacrificial substrate or after they are mounted to another substrate or an electronic component. Also, any heat incident to joining the contact tip structures to interconnection elements or mounting (e.g., by brazing) the spring contact elements to a component can advantageously be employed to "heat treat" the material of the interconnection element or spring contact element, respectively.

## Claims

1. A wafer probe interconnection element for effecting pressure connections to terminals of an electronic component comprising:
a contact tip structure pre-fabricated using lithographic processes on a sacrificial substrate, the contact tip structure having a surface with a topological contact feature;
an interconnection component joined to said contact tip structure on a surface opposite the topological contact feature and at a point offset from said contact tip structure, wherein said contact tip structure and said interconnection component form a cantilever and pedestal structure when the sacrificial substrate is separated from the contact tip structure.

2. The interconnection element according to claim 1, wherein:
the contact tip structure is elongate.

3. The interconnection element according to claim 1, wherein:
the interconnection component and the contact tip structure have different metallurgy characteristics.

4. The interconnection element according to claim 1, wherein:
the topological contact feature is in the shape of a truncated pyramid.

5. The interconnection element according to claim 1, wherein:
the interconnection component and the contact tip structure have different rigidity characteristics.

6. The interconnection element according to claim 1, wherein:
the interconnection component and the contact tip structure are joined by soldering.

7. The interconnection element according to claim 1, wherein:
the tip structure is formed by providing a masking layer on the sacrificial substrate, forming at least one opening in the masking layer, and depositing at least one layer of a metallic material into the opening.

8. The interconnection element according to claim 1, wherein:
the contact tip structure is elongate and is tapered in a first direction from a one end to an opposite end thereof.

9. The interconnection element according to claim 1, wherein:
the interconnection component is fabricated on a substrate prior to being joined with the contact tip structure.

10. The interconnection element according to claim 1, wherein:
the interconnection component is fabricated on the contact tip structure while the contact tip structure is resident on the sacrificial substrate.

11. The interconnection element according to claim 1, wherein:
the contact tip structure is designed to be suitable for making repeated pressure connections with terminals of electronic components.

12. The interconnection element according to claim 7, wherein:
the at least one opening corresponds to a location in accordance with a layout design of the terminals of the electronic component.
